(19) Europäisches Patentamt
European Patent Office
Office européen des brevets

(11) EP 4 692 824 A1

(12) **EUROPEAN PATENT APPLICATION**
published in accordance with Art. 153(4) EPC

(43) Date of publication:
**11.02.2026  Bulletin 2026/07**

(21) Application number: **24803559.4**

(22) Date of filing: **25.01.2024**

(51) International Patent Classification (IPC):
**G01R 31/396** (2019.01)  **G01R 31/392** (2019.01)
**G01R 31/367** (2019.01)  **G01R 31/36** (2020.01)
**G01R 19/00** (2006.01)  **G01R 19/165** (2006.01)

(52) Cooperative Patent Classification (CPC):
**G01R 19/00; G01R 19/165; G01R 31/36;
G01R 31/367; G01R 31/392; G01R 31/396;
Y02E 60/10**

(86) International application number:
**PCT/KR2024/001229**

(87) International publication number:
**WO 2024/232502 (14.11.2024 Gazette 2024/46)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **09.05.2023  KR 20230060037**

(71) Applicant: **LG Energy Solution, Ltd.
Seoul 07335 (KR)**

(72) Inventors:
• **SUNG, Yong Chul
Daejeon 34122 (KR)**
• **KIM, Cheol Taek
Daejeon 34122 (KR)**

(74) Representative: **Plasseraud IP
104 Rue de Richelieu
CS92104
75080 Paris Cedex 02 (FR)**

(54) **BATTERY MANAGEMENT APPARATUS AND OPERATION METHOD THEREFOR**

(57)    A battery management apparatus according to an embodiment disclosed herein includes an information obtaining unit configured to obtain an open circuit voltage of each of a plurality of battery cells and a controller configured to calculate an average open circuit voltage for the open circuit voltage of each of the plurality of battery cells, calculate a first linear regression function related to an open circuit voltage of a first battery cell among the plurality of battery cells, based on the open circuit voltage of the first battery cell and the average open circuit voltage, calculate a first error between a prediction value calculated based on the first linear regression function and the open circuit voltage of the first battery cell, and diagnose the first battery cell based on the first error.

100

```
┌──────────────────┐          ┌──────────────────┐
│   INFORMATION    │          │    CONTROLLER    │
│  OBTAINING UNIT  │──────────│       120        │
│       110        │          │                  │
└──────────────────┘          └──────────────────┘
```

FIG.2

# Description

**[Technical Field]**

<u>CROSS-REFERENCE TO RELATED APPLICATION</u>

This application claims priority to and the benefit of Korean Patent Application No. 10-2023-0060037 filed in the Korean Intellectual Property Office on May 9, 2023, the entire content of which is incorporated herein by reference.

<u>TECHNICAL FIELD</u>

Embodiments disclosed herein relate to a battery management apparatus and an operating method thereof.

**[Background Art]**

Recently, research and development of secondary batteries have been actively performed. Herein, the secondary batteries, which are chargeable/-dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

With a method for diagnosing an abnormal behavior of a voltage based on a long-term/short-term moving average by using a deviation from an average of battery cell voltages, abnormality of a battery cell may be diagnosed only when tab disconnection of a battery cell occurs or a sudden change in voltage occurs during a process of reconnecting of the disconnected battery cell. Moreover, the method of diagnosing the abnormal behavior of the voltage based on the long-term/short-term moving average uses a real-time voltage, increasing system resources.

**[Disclosure]**

**[Technical Problem]**

Embodiments disclosed herein aim to provide a battery management apparatus and an operating method thereof in which tab disconnection of a battery cell may be diagnosed based on an OCV voltage of a battery cell after charging or discharging even when a voltage does not change suddenly.

Embodiments disclosed herein aim to provide a battery management apparatus and an operating method thereof in which whether a tab is disconnected may be diagnosed based on an OCV behavior of a battery cell after charging or discharging even when an abnormal behavior of a voltage does not occur.

Technical problems of the embodiments disclosed herein are not limited to the above-described technical problems, and other unmentioned technical problems would be clearly understood by one of ordinary skill in the art from the following description.

**[Technical Solution]**

A battery management apparatus according to an embodiment disclosed herein includes an information obtaining unit configured to obtain an open circuit voltage of each of a plurality of battery cells and a controller configured to calculate an average open circuit voltage for the open circuit voltage of each of the plurality of battery cells, calculate a first linear regression function related to an open circuit voltage of a first battery cell among the plurality of battery cells, based on the open circuit voltage of the first battery cell and the average open circuit voltage, calculate a first error between a prediction value calculated based on the first linear regression function and the open circuit voltage of the first battery cell, and diagnose the first battery cell based on the first error.

In an embodiment, the information obtaining unit may be further configured to obtain the open circuit voltage of each of the plurality of battery cells for each charging after the plurality of battery cells are charged a plurality of times.

In an embodiment, the controller may be further configured to calculate the average open circuit voltage for each charging, based on an open circuit voltage of each of the plurality of battery cells, obtained for each charging and calculate the first linear regression function based on the average open circuit voltage calculated for each charging and the open circuit voltage of the first battery cell obtained for each charging.

In an embodiment, the controller may be further configured to calculate a maximum deviation and a minimum deviation between the open circuit voltage of the first battery cell and the prediction value calculated based on the first linear regression function, calculate an error rate between the open circuit voltage of the first battery cell and the prediction value calculated based on the first linear regression function, and calculate a first error of the open circuit voltage of the first battery cell based on a difference between the maximum deviation and the minimum deviation and the error rate.

In an embodiment, the controller may be further configured to calculate the first error of the open circuit voltage of the first battery cell by multiplying the difference between the maximum deviation and the minimum deviation by the error rate.

In an embodiment, the error rate may be calculated based on a determination coefficient (R-squared) error rate.

In an embodiment, the controller may be further configured to diagnose that abnormality occurs in the first battery cell when the first error is greater than or equal to a preset value.

In an embodiment, the controller may be further configured to calculate a linear regression function related to an open circuit voltage of each of the plurality of battery cells, based on the open circuit voltage of each of the plurality of battery cells and the average open circuit voltage, calculate the error between the prediction value calculated based on the linear regression function and the open circuit voltage of each of the plurality of battery cells, and diagnose each of the plurality of battery cells based on the error.

In an embodiment, the information obtaining unit may be further configured to obtain the open circuit voltage of each of the plurality of battery cells by shifting for each reference number of times.

In an embodiment, the information obtaining unit may be further configured to obtain the open circuit voltage of each of the plurality of battery cells for each discharging after the plurality of battery cells are discharged a plurality of times.

An operating method of a battery management apparatus according to an embodiment disclosed herein includes obtaining an open circuit voltage of each of a plurality of battery cells, calculating an average open circuit voltage for the open circuit voltage of each of the plurality of battery cells, calculating a first linear regression function related to an open circuit voltage of a first battery cell among the plurality of battery cells, based on the open circuit voltage of the first battery cell and the average open circuit voltage, calculating a first error between a prediction value calculated based on the first linear regression function and the open circuit voltage of the first battery cell, and diagnosing the first battery cell based on the first error.

In an embodiment, the calculating of the first error between the prediction value calculated based on the first linear regression function and the open circuit voltage of the first battery cell may include calculating a maximum deviation and a minimum deviation between the open circuit voltage of the first battery cell and the prediction value calculated based on the first linear regression function, calculating an error rate between the open circuit voltage of the first battery cell and the prediction value calculated based on the first linear regression function, and calculating a first error of the open circuit voltage of the first battery cell based on a difference between the maximum deviation and the minimum deviation and the error rate.

In an embodiment, the operating method may further include calculating a linear regression function related to an open circuit voltage of each of the plurality of battery cells, based on the open circuit voltage of each of the plurality of battery cells and the average open circuit voltage, calculating the error between the prediction value calculated based on the linear regression function and the open circuit voltage of each of the plurality of battery cells, and diagnosing each of the plurality of battery cells based on the error.

**[Advantageous Effects]**

The battery management apparatus and the operating method thereof according to an embodiment disclosed herein may diagnose whether a tab of a battery cell is disconnected, based on an OCV behavior after charging or discharging of the battery cell.

The battery management apparatus and the operating method thereof according to an embodiment disclosed herein may calculate a prediction model by applying an OCV voltage of a battery cell to an average OCV of a plurality of battery cells even when no sudden voltage behavior abnormality occurs, and diagnose tab disconnection of the battery cell based on a prediction value and a measurement value.

The battery management apparatus and the operating method thereof according to an embodiment disclosed herein may calculate a prediction model by applying an OCV voltage of a battery cell to an average OCV of a plurality of battery cells through linear regression and diagnose the battery cell based on a maximum deviation and a determination coefficient (R-squared) error rate between a prediction value and a measurement value.

Moreover, various effects recognized directly or indirectly from the disclosure may be provided.

**[Description of Drawings]**

FIG. 1 is a block diagram showing a configuration of a general battery pack.

FIG. 2 is a block diagram of a battery management apparatus according to an embodiment disclosed herein.

FIG. 3 shows an example where a battery management apparatus according to an embodiment disclosed herein calculates a linear regression function with respect to an OCV of each of a plurality of battery cells.

FIG. 4 shows an example where a battery management apparatus according to an embodiment disclosed herein calculates an error between a prediction value and a measurement value of each battery cell.

FIG. 5 is a flowchart of an operating method of a battery management apparatus according to an embodiment disclosed herein.

FIGS. 6 to 7 are flowcharts showing in detail an operating method of a battery management apparatus, according to an embodiment disclosed herein.

FIG. 8 is a block diagram showing a hardware configuration of a computing system for performing an operating method of a battery management apparatus, according to an embodiment disclosed herein.

**[Mode for Invention]**

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

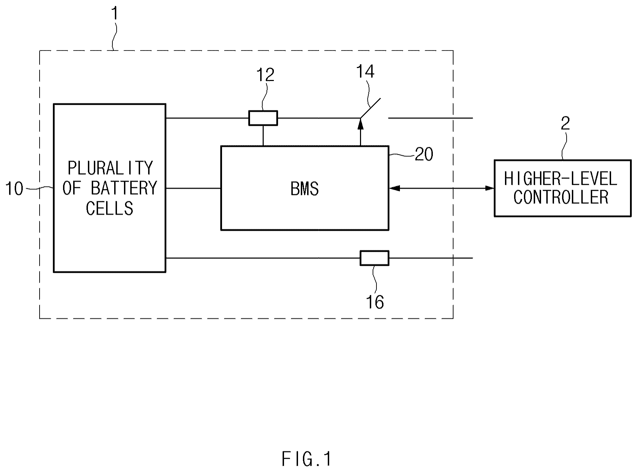

FIG. 1 is a block diagram showing a configuration of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a plurality of battery cells 10 that include one or more battery cells and are chargeable/dischargeable, a switching unit 14 serially connected to positive (+) terminal sides or negative (-) terminal sides of the plurality of battery cells 10 to control a charging/discharging current flow of the plurality of battery cells 10, and a battery management system 20 for control and management to prevent over-charging and over-discharging by monitoring voltage, current, temperature, etc., of the battery pack 1. The battery pack 1 may include the plurality of battery cells 10, the sensor 12, the switching unit 14, and the battery management system 20 provided in plural.

Herein, as the switching unit 14 which is an element for controlling a current flow for charging or discharging of the plurality of battery cells 10, for example, at least one relay, magnetic contactor, etc., may be used according to specifications of the battery pack 1.

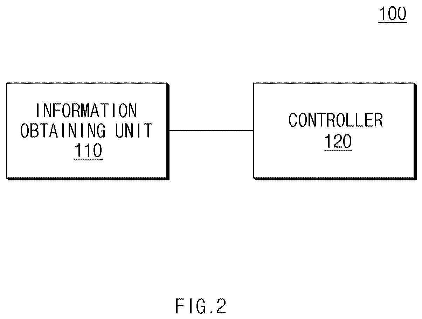

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the plurality of battery cells 10 to monitor the state of each battery cell 10. According to an embodiment, the battery management system 20 may include a battery management apparatus 100 of FIG. 2. According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1. The following operation of the battery management apparatus 100 may also be performed in various devices such as not only a battery management system (BMS) in a vehicle, but also a server, a cloud, a charger, a charger/discharger, etc.

The higher-level controller 2 may transmit a control signal regarding the plurality of battery cells 10 to the battery management system 20. Thus, the battery management system 20 may also be controlled in terms of an operation thereof based on a signal applied from the higher-level controller 2.

FIG. 2 is a block diagram of a battery management apparatus according to an embodiment disclosed herein.

Referring to FIG. 2, the battery management apparatus 100 according to an embodiment disclosed herein may include an information obtaining unit 110 and a controller 120. Depending on an embodiment, the battery management apparatus 100 may be included in the battery management system 20 of FIG. 1 or may be another device that is different from the battery management system 20 of FIG. 1. According to an embodiment, the battery management apparatus 100 may be included in various devices for managing and testing a battery cell.

The information obtaining unit 110 may obtain an open cell voltage (OCV) of each of a plurality of battery cells. For example, the information obtaining unit 110 may obtain an open circuit voltage after each of the plurality of battery cells is charged and/or discharged. According to an embodiment, the information obtaining unit 110 may obtain the open circuit voltage of each of the plurality of battery cells for each charging and/or discharging after the plurality of battery cells are charged and/or discharged a plurality of times.

According to an embodiment, the information obtaining unit 110 may obtain the open circuit voltage of each of the plurality of battery cells by performing shifting for each reference number of times. For example, there may be a limitation in memory, such that when a reference number of times is 10, the information obtaining unit 110 may delete an open circuit voltage of each of a plurality of battery cells in the 1st round upon obtaining the open circuit voltage of each of the plurality of battery cells in the 11th round. In this case, the controller 120 described below may calculate a linear regression function of each of the plurality of battery cells based on the open circuit voltages of the plurality of battery cells for the reference number of times, thereby diagnosing each of the plurality of battery cells.

The controller 120 may calculate an average open circuit voltage for the open circuit voltage of each of the plurality of battery cells. For example, the controller 120 may calculate an average open circuit voltage for the open circuit voltage of each of the plurality of battery cells, after each of the plurality of battery cells is charged. In another example, the controller 120 may calculate an average open circuit voltage for the open circuit voltage of each of the plurality of battery cells, after each of the plurality of battery cells is discharged. According to an embodiment, the controller 120 may calculate an average open circuit voltage for the open circuit voltage of each of the plurality of battery cells a plurality of times, after each charging or discharging is performed, in case that charging or discharging is performed a plurality of times.

The controller 120 may calculate a first linear regression function related to an open circuit voltage of a first battery cell among the plurality of battery cells, based on the open circuit voltage of the first battery cell and the average open circuit voltage. For example, the first battery cell may be any one of the plurality of battery cells.

According to an embodiment, the controller 120 may calculate a linear regression function related to an open circuit voltage of each of the plurality of battery cells, based on the open circuit voltage of each of the plurality of battery cells and the average open circuit voltage.

According to an embodiment, the controller 120 may calculate the average open circuit voltage for each charging based on the open circuit voltage of each of the plurality of battery cells, obtained for each charging, and calculate the first linear regression function based on the average open circuit voltage calculated for each charging and the open circuit voltage of the first battery cell, obtained for each charging.

According to an embodiment, the controller 120 may calculate the first linear regression function by using Equation 1.

[Equation 1]

$$y = ax + b$$

x: the average open circuit voltage of the plurality of battery cells, y = a prediction value for the open circuit voltage of the first battery cell

For example, the controller 120 may calculate a and b to minimize an error between the prediction value and the measurement value for the open circuit voltage of the first battery cell. According to an embodiment, the error between the prediction value and the measurement value for the open circuit voltage of the first battery cell may include any one of an absolute error, a relative error, a percentage error, a root mean square error, or a determination coefficient (R-squared) error.

According to an embodiment, the controller 120 may calculate the first linear regression function for each of the plurality of battery cells, by using Equation 1.

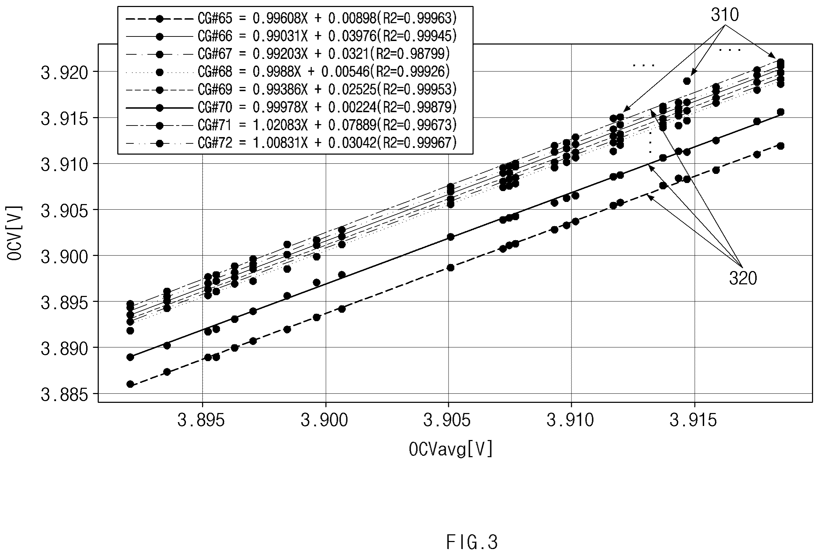

FIG. 3 shows an example where a battery management apparatus according to an embodiment disclosed herein calculates a linear regression function with respect to an OCV of each of a plurality of battery cells.

Referring to FIG. 3, the controller 120 may calculate a linear regression function 320 of each of the plurality of battery cells based on a measurement value 310 of the open circuit voltage of each of the plurality of battery cells and an average open circuit voltage of the plurality of battery cells. For example, the controller 120 may calculate the linear regression function 320 by applying the measurement value 310 of the open circuit voltage of each of the plurality of battery cells to the average open circuit voltage of the plurality of battery cells.

According to an embodiment, the controller 120 may calculate a prediction value for the open circuit voltage of each of the plurality of battery cells corresponding to the average open circuit voltage, based on the linear regression function of each of the plurality of battery cells.

According to an embodiment, the controller 120 may calculate an error rate between the measurement value of the open circuit voltage of each of the plurality of battery cells and the prediction value, calculated based on the linear regression function of each of the plurality of battery cells, for each of the plurality of battery cells, based on the determination coefficient (R-squared) error rate. For example, the controller 120 may calculate the error rate for each of the plurality of battery cells by subtracting the determination coefficient error rate from 1. In this case, the determination coefficient error rate has a value closer to 1 for a less error, such that the small calculated error rate (1 - the determination coefficient error rate) may mean the small error between the measurement value and the prediction value, and the large calculated error rate (1 - the determination coefficient error rate) may mean the large error between the measurement value and the prediction value.

Referring back to FIG. 2, the controller 120 may calculate a first error between the prediction value calculated based on the first linear regression function and the open circuit voltage of the first battery cell. For example, the controller 120 may calculate a maximum deviation and a minimum deviation between the open circuit voltage of the first battery cell and the prediction value calculated based on the first linear regression function, calculate an error rate between the open circuit voltage of the first battery cell and the prediction value

**EP 4 692 824 A1**

calculated based on the first linear regression function, and calculate a first error for the open circuit voltage of the first battery cell based on a difference and an error rate between the maximum deviation and the minimum deviation.

According to an embodiment, the controller 120 may calculate the first error of the open circuit voltage of the first battery cell by multiplying the difference between the maximum deviation and the minimum deviation by the error rate.

According to an embodiment, the error rate may be calculated based on the determination coefficient (R-squared) error rate. For example, the error rate may be a value obtained by subtracting the determination coefficient error rate from 1.

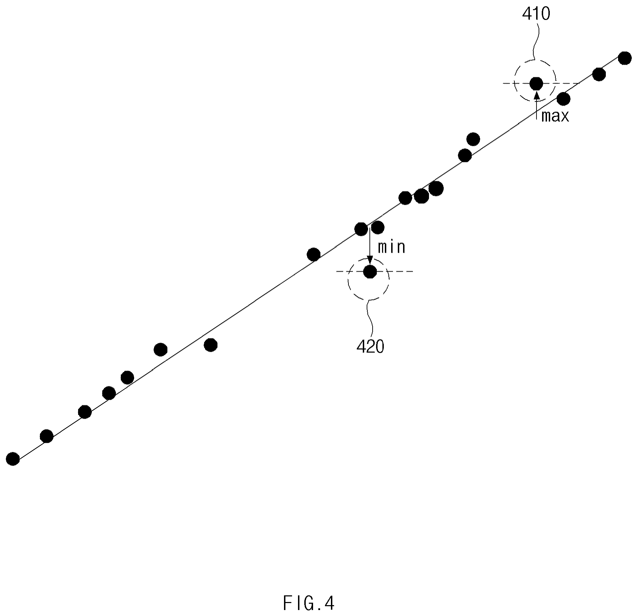

FIG. 4 shows an example where a battery management apparatus according to an embodiment disclosed herein calculates an error between a prediction value and a measurement value of each battery cell.

Referring to FIG. 4, the controller 120 may compare the measurement value of the open circuit voltage of the first battery cell with the first linear regression function to calculate a deviation. For example, the controller 120 may calculate an open circuit voltage measurement value 410 having a maximum deviation from the first linear regression function and an open circuit voltage measurement value 420 having a minimum deviation from the first linear regression function, among open circuit voltage measurement values of the first battery cell. In this case, the controller 120 may calculate a deviation between the open circuit voltage measurement value 410 having the maximum deviation and the first linear regression function and calculate a deviation between the open circuit voltage measurement value 420 having the minimum deviation and the first linear regression function, thereby calculating a difference between the maximum deviation and the minimum deviation.

While an example is shown in FIG. 4 where a measurement value of an open circuit voltage and a linear regression function are compared for one battery cell to calculate a maximum deviation and a minimum deviation, the present disclosure is not limited thereto, such that the controller 120 may compare an open circuit voltage of each of a plurality of battery cells with a linear regression function of each of the plurality of battery cells to calculate a maximum deviation and a minimum deviation for each of the plurality of battery cells.

Referring back to FIG. 2, the controller 120 may diagnose the first battery cell based on the first error. For example, the controller 120 may diagnose that abnormality occurs in the first battery cell when the first error is greater than or equal to a preset value.

According to an embodiment, the first error is calculated by multiplying the difference between the maximum deviation and the minimum deviation of the first battery cell by the error rate (1 - the determination coefficient error rate), such that the controller 120 may diagnose whether abnormality occurs in the first battery cell by considering the maximum deviation, the minimum deviation, and the overall error rate at the same time.

According to an embodiment, the controller 120 may calculate the linear regression function related to the open circuit voltage of each of the plurality of battery cells based on the open circuit voltage of each of the plurality of battery cells and the average open circuit voltage, calculate the error between the prediction value calculated based on the linear regression function and the open circuit voltage of each of the plurality of battery cells, and diagnose each of the plurality of battery cells based on the error.

According to an embodiment, the battery management apparatus 100 disclosed herein may calculate the linear regression function by applying the open circuit voltage of the plurality of battery cells to the average open circuit voltage after each of the plurality of battery cells is charged or discharged under the same condition, and compare the prediction value calculated based on the linear regression function with the measurement value, thereby diagnosing each of the plurality of battery cells.

The battery management apparatus 100 according to an embodiment disclosed herein may diagnose whether a tab of a battery cell is disconnected, based on an OCV behavior after charging or discharging of the battery cell.

The battery management apparatus 100 according to an embodiment disclosed herein may calculate a prediction model by applying an OCV voltage of a battery cell to an average OCV of a plurality of battery cells even when no sudden voltage behavior abnormality occurs, and diagnose tab disconnection of the battery cell based on a prediction value and a measurement value.

The battery management apparatus 100 according to an embodiment disclosed herein may calculate a prediction model by applying an OCV voltage of a battery cell to an average OCV of a plurality of battery cells through linear regression and diagnose the battery cell based on a maximum deviation and a determination coefficient (R-squared) error rate between a prediction value and a measurement value.

Moreover, the battery management apparatus 100 according to an embodiment disclosed herein may obtain the open circuit voltage of each of the plurality of battery cells by shifting for each reference number of times, re-calculate the linear regression function for each reference number of times, and calculate an error to diagnose each battery cell, thereby accurately each battery cell even in an environment with an insufficient memory.

Furthermore, in an environment with a sufficient memory, the battery management apparatus 100 according to an embodiment disclosed herein may continuously store the open circuit voltage of each of the plurality of battery cells, calculate the accurate linear regression function based on the continuously stored open circuit voltage, and calculate an error to diagnose each battery cell, thereby accurately each battery cell.

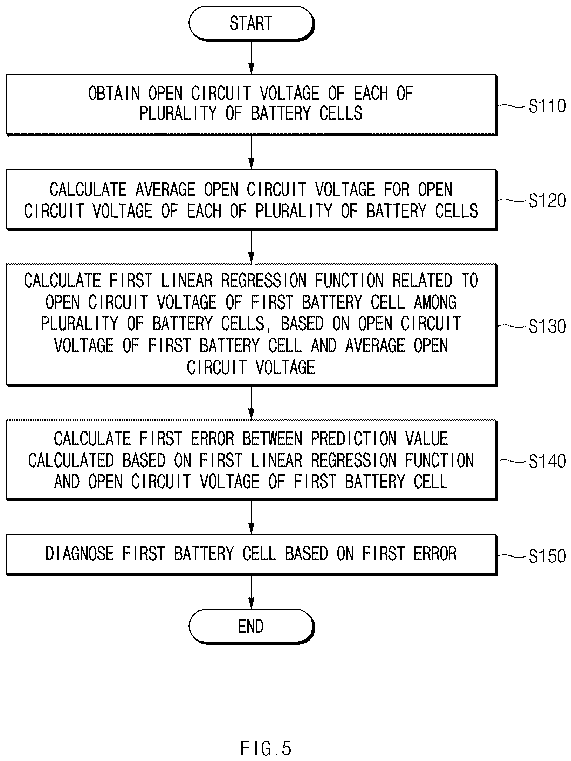

FIG. 5 is a flowchart of an operating method of a battery management apparatus according to an embodiment disclosed herein. According to an embodiment, operations shown in FIG. 5 may be performed by the battery management apparatus 100 of FIG. 2.

Referring to FIG. 5, in operation S110, the information obtaining unit 110 may obtain the open circuit voltage of each of the plurality of battery cells.

In operation S120, the controller 120 may calculate an average open circuit voltage for the open circuit voltage of each of the plurality of battery cells.

In operation S130, the controller 120 may calculate a first linear regression function related to an open circuit voltage of a first battery cell among the plurality of battery cells, based on the open circuit voltage of the first battery cell and the average open circuit voltage.

In operation S140, the controller 120 may calculate a first error between the prediction value calculated based on the first linear regression function and the open circuit voltage of the first battery cell.

In operation S150, the controller 120 may diagnose the first battery cell based on the first error.

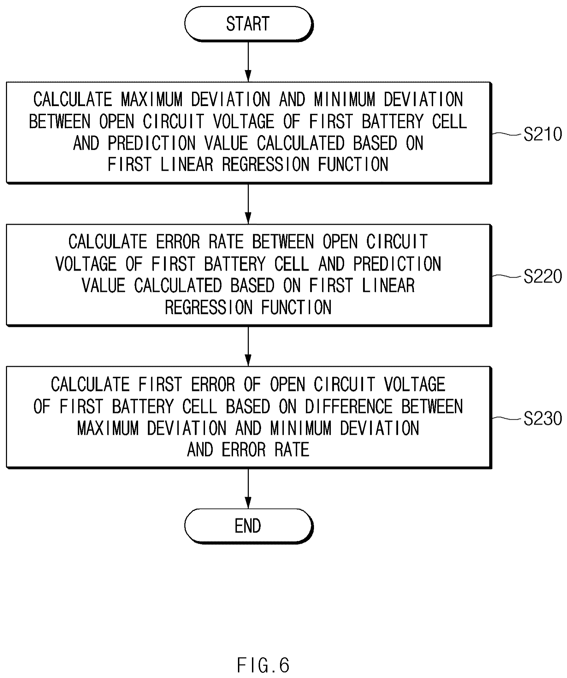

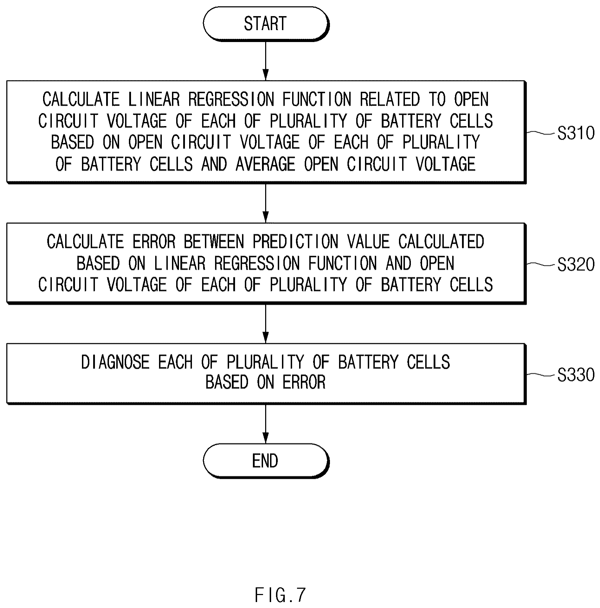

FIGS. 6 to 7 are flowcharts showing in detail an operating method of a battery management apparatus, according to an embodiment disclosed herein. According to an embodiment, operations shown in FIGS. 6 and 7 may be performed by the battery management apparatus 100 of FIG. 2.

Referring to FIG. 6, in operation S210, the controller 120 may calculate the maximum deviation and the minimum deviation between the open circuit voltage of the first battery cell and the prediction value calculated based on the first linear regression function.

In operation S220, the controller 120 may calculate the error rate between the open circuit voltage of the first battery cell and the prediction value calculated based on the first linear regression function.

In operation S230, the controller 120 may calculate the first error of the open circuit voltage of the first battery cell based on the difference between the maximum deviation and the minimum deviation and the error rate.

According to an embodiment, operations S210 to S230 may be included in operation S140 of FIG. 5.

Referring to FIG. 7, in operation S310, the controller 120 may calculate the linear regression function related to an open circuit voltage of each of the plurality of battery cells, based on the open circuit voltage of each of the plurality of battery cells and the average open circuit voltage.

In operation S320, the controller 120 may calculate the error between the prediction value calculated based on the linear regression function and the open circuit voltage of each of the plurality of battery cells.

In operation S330, the controller 120 may diagnose each of the plurality of battery cells based on the error.

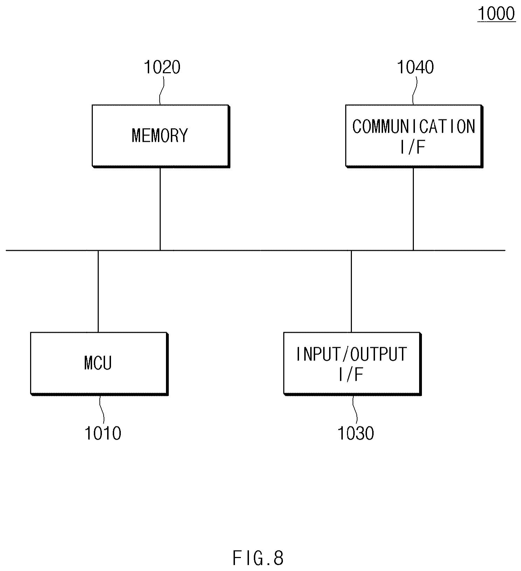

FIG. 8 is a block diagram showing a hardware configuration of a computing system for performing an operating method of a battery management apparatus, according to an embodiment disclosed herein.

Referring to FIG. 8, a computing system 1000 according to an embodiment disclosed herein may include an MCU 1010, a memory 1020, an input/output I/F 1030, and a communication I/F 1040.

The MCU 1010 may be a processor that executes various programs (e.g., a battery cell open circuit voltage collection program, a linear regression function calculation program, an error calculation program, etc.) stored in the memory 1020, processes various data including an open circuit voltage of a battery cell, a linear regression function, an error, etc., through these programs, and performs the above-described functions of the controller included in the battery management apparatus shown in FIG. 2.

The memory 1020 may store various programs such as a battery cell open circuit voltage collection program, a linear regression function calculation program, an error calculation program, a battery cell diagnosis program, etc. Moreover, the memory 1020 may store various information such as an open circuit voltage of a battery cell, a linear regression function, an error, etc.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery management apparatus may transmit and receive various information including the open circuit voltage of the battery cell, the linear regression function, the error, etc., from an external server separately provided through the communication I/F 1040.

As such, a computer program according to an embodiment disclosed herein may be recorded in the memory 1020 and processed by the MCU 1010, thus being implemented as a module that performs functions shown in FIG. 2.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

**Claims**

1. A battery management apparatus comprising:

    an information obtaining unit configured to obtain an open circuit voltage of each of a plurality of battery cells; and
    a controller configured to:

        calculate an average open circuit voltage for the open circuit voltage of each of the plurality of battery cells;
        calculate a first linear regression function related to an open circuit voltage of a first battery cell among the plurality of battery cells, based on the open circuit voltage of the first battery cell and the average open circuit voltage;
        calculate a first error between a prediction value calculated based on the first linear regression function and the open circuit voltage of the first battery cell; and
        diagnose the first battery cell based on the first error.

2. The battery management apparatus of claim 1, wherein the information obtaining unit is further configured to obtain the open circuit voltage of each of the plurality of battery cells for each charging after the plurality of battery cells are charged a plurality of times.

3. The battery management apparatus of claim 2, wherein the controller is further configured to:

    calculate the average open circuit voltage for each charging, based on an open circuit voltage of each of the plurality of battery cells, obtained for each charging; and
    calculate the first linear regression function based on the average open circuit voltage calculated for each charging and the open circuit voltage of the first battery cell obtained for each charging.

4. The battery management apparatus of claim 1, wherein the controller is further configured to:

    calculate a maximum deviation and a minimum deviation between the open circuit voltage of the first battery cell and the prediction value calculated based on the first linear regression function;
    calculate an error rate between the open circuit voltage of the first battery cell and the prediction value calculated based on the first linear regression function; and
    calculate a first error of the open circuit voltage of the first battery cell based on a difference between the maximum deviation and the minimum deviation and the error rate.

5. The battery management apparatus of claim 4, wherein the controller is further configured to calculate the first error of the open circuit voltage of the first battery cell by multiplying the difference between the maximum deviation and the minimum deviation by the error rate.

6. The battery management apparatus of claim 4, wherein the error rate is calculated based on a determination coefficient (R-squared) error rate.

7. The battery management apparatus of claim 1, wherein the controller is further configured to diagnose that abnormality occurs in the first battery cell when the first error is greater than or equal to a preset value.

8. The battery management apparatus of claim 1, wherein the controller is further configured to:

    calculate a linear regression function related to an open circuit voltage of each of the plurality of battery cells, based on the open circuit voltage of each of the plurality of battery cells and the average open circuit voltage;
    calculate the error between the prediction value calculated based on the linear regression function and the open circuit voltage of each of the plurality of battery cells; and
    diagnose each of the plurality of battery cells based on the error.

9. The battery management apparatus of claim 1, wherein the information obtaining unit is further configured to obtain the open circuit voltage of each of the plurality of battery cells by shifting for each reference number of times.

**10.** The battery management apparatus of claim 1, wherein the information obtaining unit is further configured to obtain the open circuit voltage of each of the plurality of battery cells for each discharging after the plurality of battery cells are discharged a plurality of times.

**11.** An operating method of a battery management apparatus, the operating method comprising:

obtaining an open circuit voltage of each of a plurality of battery cells;
calculating an average open circuit voltage for the open circuit voltage of each of the plurality of battery cells;
calculating a first linear regression function related to an open circuit voltage of a first battery cell among the plurality of battery cells, based on the open circuit voltage of the first battery cell and the average open circuit voltage;
calculating a first error between a prediction value calculated based on the first linear regression function and the open circuit voltage of the first battery cell; and
diagnosing the first battery cell based on the first error.

**12.** The operating method of claim 11, wherein the calculating of the first error between the prediction value calculated based on the first linear regression function and the open circuit voltage of the first battery cell comprises:

calculating a maximum deviation and a minimum deviation between the open circuit voltage of the first battery cell and the prediction value calculated based on the first linear regression function;
calculating an error rate between the open circuit voltage of the first battery cell and the prediction value calculated based on the first linear regression function; and
calculating a first error of the open circuit voltage of the first battery cell based on a difference between the maximum deviation and the minimum deviation and the error rate.

**13.** The operating method of claim 11, further comprising:

calculating a linear regression function related to an open circuit voltage of each of the plurality of battery cells, based on the open circuit voltage of each of the plurality of battery cells and the average open circuit voltage;
calculating the error between the prediction value calculated based on the linear regression function and the open circuit voltage of each of the plurality of battery cells; and
diagnosing each of the plurality of battery cells based on the error.

FIG.1

100

| INFORMATION OBTAINING UNIT 110 | | CONTROLLER 120 |
| --- | --- | --- |

FIG.2

FIG.3

FIG.4

START

OBTAIN OPEN CIRCUIT VOLTAGE OF EACH OF PLURALITY OF BATTERY CELLS —— S110

CALCULATE AVERAGE OPEN CIRCUIT VOLTAGE FOR OPEN CIRCUIT VOLTAGE OF EACH OF PLURALITY OF BATTERY CELLS —— S120

CALCULATE FIRST LINEAR REGRESSION FUNCTION RELATED TO OPEN CIRCUIT VOLTAGE OF FIRST BATTERY CELL AMONG PLURALITY OF BATTERY CELLS, BASED ON OPEN CIRCUIT VOLTAGE OF FIRST BATTERY CELL AND AVERAGE OPEN CIRCUIT VOLTAGE —— S130

CALCULATE FIRST ERROR BETWEEN PREDICTION VALUE CALCULATED BASED ON FIRST LINEAR REGRESSION FUNCTION AND OPEN CIRCUIT VOLTAGE OF FIRST BATTERY CELL —— S140

DIAGNOSE FIRST BATTERY CELL BASED ON FIRST ERROR —— S150

END

FIG.5

START

CALCULATE MAXIMUM DEVIATION AND MINIMUM DEVIATION BETWEEN OPEN CIRCUIT VOLTAGE OF FIRST BATTERY CELL AND PREDICTION VALUE CALCULATED BASED ON FIRST LINEAR REGRESSION FUNCTION ⟋S210

CALCULATE ERROR RATE BETWEEN OPEN CIRCUIT VOLTAGE OF FIRST BATTERY CELL AND PREDICTION VALUE CALCULATED BASED ON FIRST LINEAR REGRESSION FUNCTION ⟋S220

CALCULATE FIRST ERROR OF OPEN CIRCUIT VOLTAGE OF FIRST BATTERY CELL BASED ON DIFFERENCE BETWEEN MAXIMUM DEVIATION AND MINIMUM DEVIATION AND ERROR RATE ⟋S230

END

FIG.6

START

CALCULATE LINEAR REGRESSION FUNCTION RELATED TO OPEN CIRCUIT VOLTAGE OF EACH OF PLURALITY OF BATTERY CELLS BASED ON OPEN CIRCUIT VOLTAGE OF EACH OF PLURALITY OF BATTERY CELLS AND AVERAGE OPEN CIRCUIT VOLTAGE ～S310

CALCULATE ERROR BETWEEN PREDICTION VALUE CALCULATED BASED ON LINEAR REGRESSION FUNCTION AND OPEN CIRCUIT VOLTAGE OF EACH OF PLURALITY OF BATTERY CELLS ～S320

DIAGNOSE EACH OF PLURALITY OF BATTERY CELLS BASED ON ERROR ～S330

END

FIG.7

<u>1000</u>

1020

1040

MEMORY

COMMUNICATION
I/F

MCU

INPUT/OUTPUT
I/F

1010

1030

FIG.8

## INTERNATIONAL SEARCH REPORT

International application No.

**PCT/KR2024/001229**

### A. CLASSIFICATION OF SUBJECT MATTER

**G01R 31/396**(2019.01)i; **G01R 31/392**(2019.01)i; **G01R 31/367**(2019.01)i; **G01R 31/36**(2006.01)i; **G01R 19/00**(2006.01)i; **G01R 19/165**(2006.01)i

According to International Patent Classification (IPC) or to both national classification and IPC

### B. FIELDS SEARCHED

Minimum documentation searched (classification system followed by classification symbols)

G01R 31/396(2019.01); B60L 11/18(2006.01); G01R 31/36(2006.01); H01M 10/42(2006.01); H01M 10/48(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 개방 회로 전압(open circuit voltage), 평균 (average), 선형 회귀 함수(linear regression function), 오차(error)

### C. DOCUMENTS CONSIDERED TO BE RELEVANT

| Category* | Citation of document, with indication, where appropriate, of the relevant passages | Relevant to claim No. |
|---|---|---|
| A | KR 10-2013-0063406 A (SAMSUNG SDI CO., LTD.) 14 June 2013 (2013-06-14) See paragraphs [0045]-[0053] and figures 3-5. | 1-13 |
| A | JP 7214884 B2 (TOSHIBA CORPORATION) 30 January 2023 (2023-01-30) See claim 3 and figure 1. | 1-13 |
| A | KR 10-2008-0039654 A (SAMSUNG SDI CO., LTD.) 07 May 2008 (2008-05-07) See paragraphs [0019]-[0032] and figure 1. | 1-13 |
| A | JP 2015-227840 A (MAZDA MOTOR CORP.) 17 December 2015 (2015-12-17) See paragraphs [0034]-[0040] and figures 1-2. | 1-13 |
| A | JP 2017-219404 A (HITACHI CHEMICAL CO., LTD.) 14 December 2017 (2017-12-14) See paragraphs [0030]-[0039] and figure 2. | 1-13 |

☐ Further documents are listed in the continuation of Box C.    ☑ See patent family annex.

| | |
|---|---|
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **23 April 2024** | **24 April 2024** |

| Name and mailing address of the ISA/KR | Authorized officer |
|---|---|
| **Korean Intellectual Property Office** <br> **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/001229**

| Patent document cited in search report | | | Publication date (day/month/year) | Patent family member(s) | | | Publication date (day/month/year) |
|---|---|---|---|---|---|---|---|
| KR | 10-2013-0063406 | A | 14 June 2013 | KR | 10-1648889 | B1 | 18 August 2016 |
| | | | | US | 2013-0144547 | A1 | 06 June 2013 |
| | | | | US | 9599675 | B2 | 21 March 2017 |
| JP | 7214884 | B2 | 30 January 2023 | EP | 4123322 | A1 | 25 January 2023 |
| | | | | EP | 4123322 | A4 | 13 December 2023 |
| | | | | WO | 2021-186512 | A1 | 23 September 2021 |
| KR | 10-2008-0039654 | A | 07 May 2008 | CN | 101174710 | A | 07 May 2008 |
| | | | | CN | 101174710 | B | 07 March 2012 |
| | | | | EP | 1919060 | A2 | 07 May 2008 |
| | | | | EP | 1919060 | A3 | 21 May 2008 |
| | | | | EP | 1919060 | B1 | 14 March 2012 |
| | | | | JP | 2008-116433 | A | 22 May 2008 |
| | | | | JP | 4949086 | B2 | 06 June 2012 |
| | | | | KR | 10-0839384 | B1 | 19 June 2008 |
| | | | | US | 2008-0100265 | A1 | 01 May 2008 |
| JP | 2015-227840 | A | 17 December 2015 | JP | 6201899 | B2 | 27 September 2017 |
| JP | 2017-219404 | A | 14 December 2017 | JP | 6674139 | B2 | 01 April 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230060037